Europäisches Patentamt

European Patent Office

Office européen des brevets

(11) Veröffentlichungsnummer: **0 470 359 A2**

## EUROPÄISCHE PATENTANMELDUNG

(21) Anmeldenummer: **91110855.3**

(22) Anmeldetag: **01.07.91**

(51) Int. Cl.5: **C23C 28/00**, C23C 14/06

(30) Priorität: **08.08.90 CH 2587/90**

(43) Veröffentlichungstag der Anmeldung:
**12.02.92 Patentblatt 92/07**

(84) Benannte Vertragsstaaten:
**DE ES FR GB IT SE**

(71) Anmelder: **BALZERS AKTIENGESELLSCHAFT**

**FL-9496 Balzers(LI)**

(72) Erfinder: **Bergmann, Erich, Dr.**
**Sarganserstrasse 58**
**CH-8887 Mels(CH)**
Erfinder: **Schulz, Hans, Dr.**
**Alte Churerstrasse 772**
**FL-9496 Balzers(LI)**

(74) Vertreter: **Keller, René, Dr. et al**
**Patentanwälte Hartmut Keller, Dr. René**
**Keller Postfach 12**
**CH-3000 Bern 7(CH)**

(54) **Beschichtetes Werkzeug.**

(57) Ein Werkzeuggrundkörper (3) ist mit einer oder mehreren Doppelschichten (1) beschichtet, wobei die frei, an der Werkzeugaußenseite liegende Schicht eine geringe Löslichkeit und/oder unterschiedliche Kristallgitterstruktur gegenüber Titan und/oder Nickel und/oder Kupfer bzw. deren Legierungen hat. Diese Schicht wird als eine kubische bzw. hexagonal kristallisierende Chromstickstoff- bzw. Chromkohlenstoffkristallschicht ausgebildet. Die zweite Schicht (1b) der Doppelschicht (1) ist eine Titannitrid- bzw. eine Titankarbonitridschicht.

Bei der zerspanenden und umformenden Bearbeitung von insbesondere Titan, Nickel, und Kupfer sowie deren Legierungen werden mit den erfindungsgemäßen Werkzeugen lange Standzeiten erreicht.

Fig. 1

EP 0 470 359 A2

Die Erfindung betrifft ein beschichtetes Werkzeug gemäß dem Oberbegriff des Patentanspruchs 1.

Aus P.A. Dearnley, A.N. Grearson, "Evaluation of Principal Wear Mechanisms of Cemented Carbides and Ceramics Used for Machining Titanium Alloy IMI 318", Materials Sciences and Technology, Jan. 1986, Vol. 2, pp 47 - 58, sind beschichtete und unbeschichtete Hartmetalle (cemented carbides) und keramische Werkzeuge bekannt. Die bekannten Werkzeuge haben Beschichtungen aus TiC, $TiB_2$ und HfN, Doppelschichten aus TiC-TiN, $TiC-Al_2O_3$ und gamma-layer-$Al_2O_3$ sowie mehrfache Doppelschichten aus TiC-TiN-TiC-....TiN. Mit den Werkzeugen wurden Titan und Titanlegierungen bearbeitet. Wie aus obiger Veröffentlichung ersichtlich, ist die Standzeit sowohl der beschichteten als auch der unbeschichteten Werkzeuge bei der Bearbeitung gering. Die Werkzeuge werden hauptsächlich durch Auskehlung in der Nähe ihrer Schneide und durch Kolkverschleiß zerstört. Mikroskopische Untersuchungen zeigten Ausbrüche in der Schicht bis an die Grenzfläche zum Werkzeuggrundkörper heran.

Der Erfindung liegt die Aufgabe zugrunde, ein beschichtetes Werkzeug zu schaffen, das eine gegenüber bekannten Werkzeugen hohe Standzeit bei der Bearbeitung von Nichteisenmetallen und deren Legierungen aufweist.

Die Lösung der Aufgabe ist Gegenstand des Patentanspruchs 1. In den Patentansprüchen 2 bis 10 sind bevorzugte Ausführungsarten des Werkzeuges beschrieben.

Im folgenden werden Beispiele des erfindungsgemäßen Werkzeuges anhand von Zeichnungen näher erläutert. Es zeigen:

Fig. 1   einen schematischen Querschnitt durch die Beschichtung eines erfindungsgemäßen Werkstückes,

Fig. 2   kristallographische Ebenen von Chrom und Titan unter Angabe der Gitterabstände in Pikometer, wobei

a. die kristallographische 110-Ebene von kubischem Chrom,

b. die kristallographische 100-Ebene von hexagonalem $\alpha$-Titan,

c. die kristallographische 110-Ebene von hexagonalem $\alpha$-Titan, und

d. die kristallographische 001-Ebene von hexagonalem $\alpha$-Titan darstellt;

Fig. 3   einen schematischen Längsschnitt durch eine Aufdampfanlage zur Beschichtung der Werkstücke,

Fig. 4   kristallographische Ebenen von Chromnitrid ($Cr_2N$) und Nickel unter Angabe der Gitterabstände in Pikometer, wobei

a. die kristallographische 111-Ebene von hexagonalem Chromnitrid,

b. die kristallographische 100-Ebene von kubischem Nickel,

c. die kristallographische 110-Ebene von kubischem Nickel, und

d. die kristallographische 111-Ebene von kubischem Nickel darstellt, sowie

Fig. 5   einen Querschnitt durch eine mehrfach beschichtetes Werkzeug.

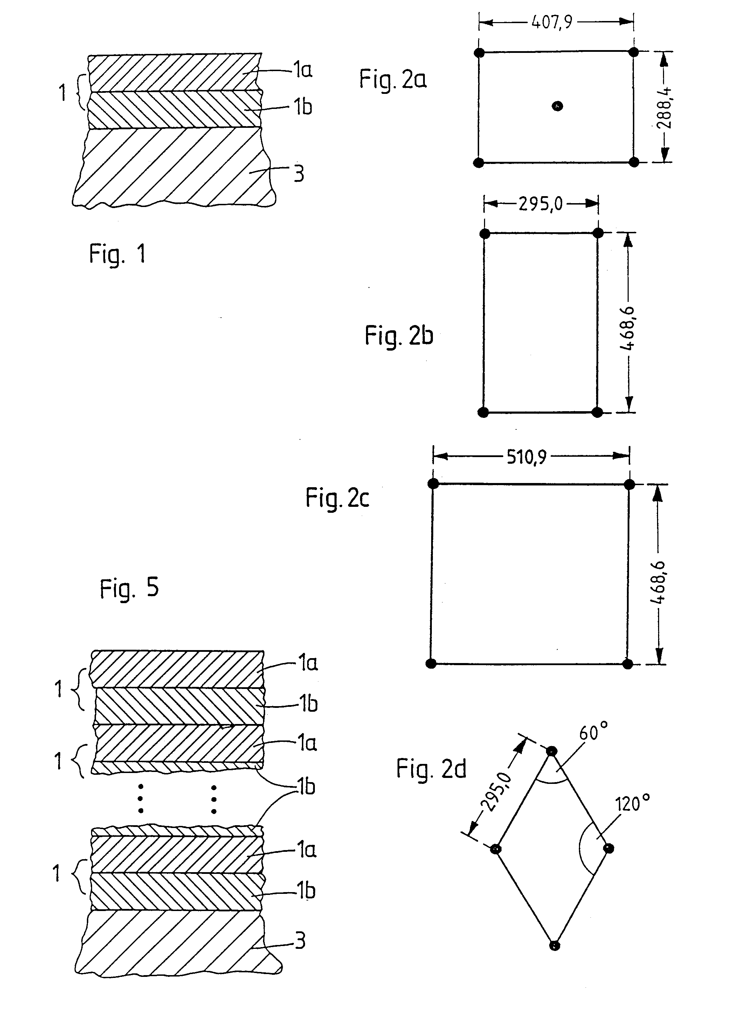

Die in **Figur 1** schematisch im Querschnitt dargestellte Beschichtung eines erfindungsgemäßen Werkzeuges hat eine Doppelschicht **1**. Die beiden Schichten **1a** und **1b** sind aus der Gasphase mit einem unten beschrieben Verfahren auf den Werkzeuggrundkörper **3** abschieden. Die freie, an der Werkzeugaußenseite liegende Oberschicht **1a** der Doppelschicht **1** besteht im wesentlichen aus einem Nitrid, Karbid oder Karbonitrid des Chroms, in dem hier ausgeführten Beispiel aus einem Karbid des Chroms, und die Unterschicht **1b** enthält ein Element der Gruppe IVb des Periodensystems, hier ein Nitrid des Titans. Das Chrom (Cr) zu Kohlenstoffverhältnis der Oberschicht **1a**, die eine in Figur **2a** dargestellte kubische Kristallstruktur hat, beträgt 2,5 : 1 ($CrC_{0.4}$).

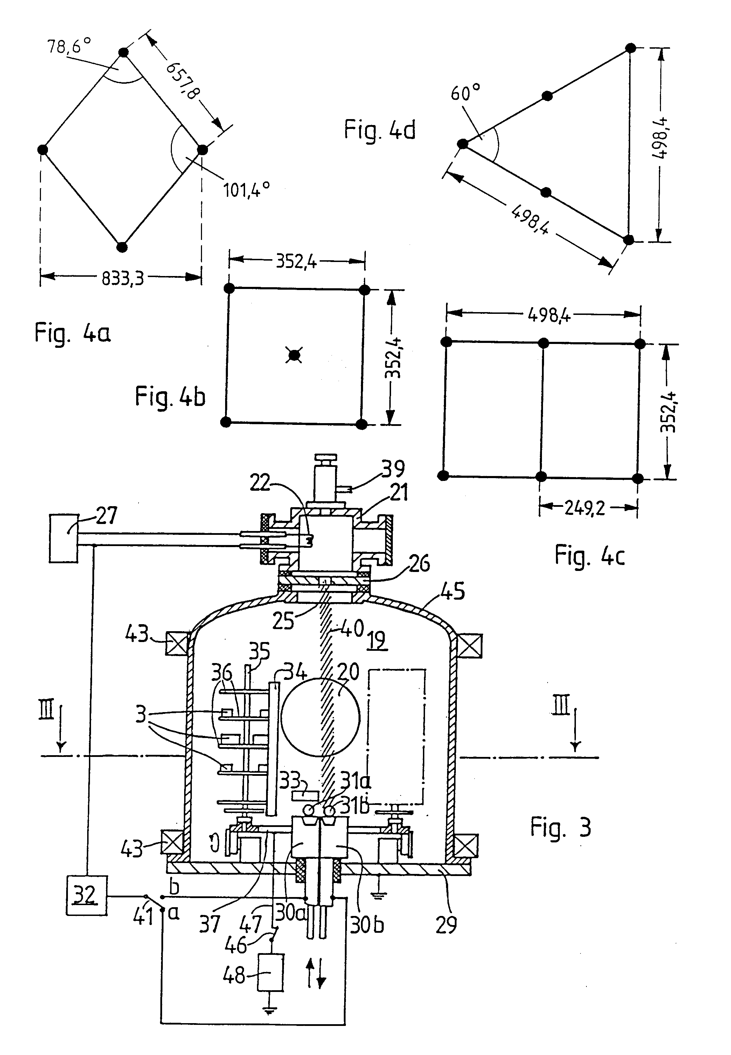

**Figur 3** zeigt eine schematische Darstellung einer beispielsweisen Aufdampfanlage zur Beschichtung der erfindungsgemäßen Werkzeuge. Die Aufdampfanlage hat eine Vakuumkammer **19** mit einem Evakuierungsanschluß **20** und eine Glühkathodenkammer **21** mit einer Glühkathode **22**, die über eine Öffnung **25** mit der Vakuumkammer **19** verbunden ist. Der die Öffnung **25** beinhaltende Boden **26** der Glühkathodenkammer **21** ist gegenüber den Wänden der Vakuumkammer **19** elektrisch isoliert. Die Wendel der Glühkathode **22** ist mit einem Stromversorgungsgerät **27** verbunden. Unterhalb der Öffnung **25** befindet sich über dem Boden **29** der Vakuumkammer **19** ein zweiteiliger, kühlbarer Tiegel **30**, dessen beide Hälften **30a** und **30b** elektrisch voneinander isoliert sind. In dem einen Tiegel **30a** befinden sich Titantabletten **31a** als festes Material und in dem anderen Tiegel **30b** Chromtabletten **31b**. Mit einer verschiebbaren Blende **33** ist das Titan **31a**, das Chrom **31b** oder beide abdeckbar. In der Vakuumkammer **19** sind sechs um die Längsachse der Vakuumkammer **19** drehbare, elektrisch leitende Träger **35**, von denen einer detailliert und ein anderer nur angedeutet in **Figur 3** dargestellt sind, vorhanden, an denen die zu beschichtenden vierschneidigen HSS-Schaftfräser der Zusammensetzung S6-5-2-10 mit einem Durchmesser von etwa 10 mm als Werkzeuggrundkörper **3** an je einer der Halterung **36** des Trägers **35** gehalten werden. Die Träger **35** sind um ihre Achse drehbar auf einem Drehteller **37** angeordnet und durch diesen untereinander elektrisch verbunden. Der Drehteller 37 ist gegenüber dem Boden 29 und den Wänden der Vakuumkammer 19 elektrisch isoliert. Die Halterungen 36 sind mit den Trägern 35 elektrisch leitend verbunden. Die an den Halterungen 36 gehaltenen Grundkörper 3 sind mit einer in Figur 3 schematisch dargestellten weiteren Blende 34 gegenüber dem Material (Titan 31a und Chrom 31b) in den Tiegeln 30a und 30b abdeckbar.

In die Glühkathodenkammer 21 mündet eine Gaszuleitung 39, die über die Öffnung 25 mit der Vakuumkammer 19 verbunden ist. Je eine schematisch dargestellte Magnetspule 43 befindet sich gerade oberhalb des Bodens 29 und am Anschluß eines Deckelteils 45 der Vakuumkammer 19 zur Erzeugung eines annähernd parallelen vertikalen Magnetfelds, welches einen von der Glühkathode 22 ausgehenden Niedervoltbogen 40 auf den Tiegel 30a bzw. 30b ablenkt, dessen Material 31 gerade verdampft werden soll. Die Stromversorgung des Niedervoltbogens 40 erfolgt durch ein Stromversorgungsgerät 32, welches mit der Glühkathode 22 und über einen Wahlschalter 41 entweder mit dem Tiegel 30a oder 30b elektrisch verbunden ist, je nachdem welches Material 31 verdampft werden soll.

Der Drehteller 37 ist über eine elektrische Leitung 47 und einen geschlossenen Schalter 46 mit einem einstellbaren Spannungsgenerator 48, dessen anderer Pol geerdet ist, verbunden.

Zur Herstellung obiger Beschichtung werden die Grundkörper 3 an den Halterungen 36 der Träger 35 befestigt und Titan 31a sowie Chrom 31b in die Tiegel 30a und 30b gelegt. Anschließend wird die Vakuumkammer 19 geschlossen, evakuiert und die zu beschichtenden Oberflächen der Gegenstände 3 entsprechend einem in der DE-OS 34 06 953 bzw. der CH-PS 658 545 beschriebenen Verfahren mit dem Niedervoltbogen 40 erhitzt und entsprechend einem in der CH-PS 631 743 beschrieben Verfahren gereinigt. Die Blende 33 deckt währenddessen das Titan 31a und das Chrom 31b in den Tiegeln 30a und 30b ab.

Anschließend wird die Blende 33 von den Titantabletten 31a weggeschoben und der Niedervoltbogen 40 auf den mit Titantabletten 31a gefüllten Tiegel 30a mittels des durch die Spule 43 erzeugten Magnetfeldes gerichtet. Der Wahlschalter 41 ist in der Stellung 41b. Nach einer Minute Verdampfen von reinem Titan wird Stickstoff durch die Gaszuleitung 39 in die Vakuumkammer 19 eingelassen, wobei der Gasfluß über den Gesamtdruck so geregelt wird, daß sich stöchiometrisches Titannitrid (TiN) bildet. Nach einer Bedampfungszeit von vierzig Minuten wird der Stickstoffzufluß unterbrochen, die Blende 33 von den Chromtabletten 31b weggeschoben, der Wahlschalter 41 in seine Stellung 41a geschaltet und der Niedervoltbogen 40 auf den mit Chromtabletten 31b gefüllten Tiegel 30b gerichtet. Nach einer Minute, in der nur Chrom sublimiert wird, wird Azetylen ($C_2H_2$) mit einem Fluß von sechzig Standardkubikzentimetern pro Minute durch die Gaszuleitung 39 eingelassen. Die Chrom-Kohlenstoffschicht wächst zu mindestens 70% kubisch raumzentriert parallel zur in Figur 2a dargestellten 110-Kristallebene auf; nur maximal 30 Volumenprozent wachsen als orthorhombische Phasen des $Cr_7C_3$ und $Cr_3C_2$ auf. In Figur 2a sind die Gitterkonstanten in Pikometer (pm) angegeben. Nach dreißig Minuten wird der Niedervoltbogen 40 abgeschaltet und der Gasfluß unterbrochen. Das Werkstück hat jetzt eine 2 $\mu$m dicke Titannitridschicht 1b als Unterschicht und eine 3 $\mu$m dicke kubische Chromkarbidschicht 1a ($CrC_{0.4}$) als Oberschicht, wobei die Summe der Schichtbereiche mit orthorhombischen Phasen von $Cr_7C_3$ und $Cr_3C_2$ kleiner als dreißig Volumenprozent ist.

Beim Zerspanungsversuch wurde eine Titanlegierung TiAl6V4 mit einer Härte von 320 HV durch Umfangsfräsen mit den erfindungsgemäß beschichteten Schaftfräsern als Werkzeug bei einer Schnittgeschwindigkeit von 78,5 m/min, einem Vorschub von 0,0375 mm/Umdrehung und einer Zustellung von 1,5 mm bearbeitet. Es wurden Standwege im Mittel von 6,9 m erreicht. Zum Vergleich trat bei unbeschichteten Fräsern nach einem Fräsweg von 3,1 m das Standzeitende durch Blankbremsung (Zerstörung des Fräsers) ein. Wurde nur eine einzige TiN-Schicht verwendet, so trat Blankbremsung nach 4,9 m und bei nur einer einzigen $CrC_{0.4}$-Schicht nach 5,1 m auf.

Die Anzahl der einzelnen Schichten, also die Anzahl der Grenzflächen beeinflußt das Zähigkeitsverhalten eines beschichteten Werkzeuges. Die Anforderungen an die Zähigkeit eines Werkzeuges erhöhen sich mit abnehmender Steifigkeit der Werkzeugmaschine. Weiterhin bedingen unterbrochene Schnitte und hohe Vorschübe Werkzeuge mit günstigen Zähigkeitseigenschaften. Die Anzahl der Doppelschichten muß so gewählt werden, daß sich eine optimale Schichtzähigkeit für den geforderten Anwendungsfall ergibt.

Hartmetall-Wendeschneidplatten des Typs K10 wurden mit 10 bzw. 50 Doppelschichten $CrC_{0.4}$/TiN beschichtet. Die Zerspanung der Legierung TiAl6V4 mit einer Festigkeit von 1100 N/mm$^2$ erfolgte bei einer Schnittgeschwindigkeit von 27 m/min und einem Vorschub von 0,2 mm/Zahn. Mit einem unbeschichteten Werkzeug wurden 730 mm zerspant, mit 10 Doppelschichten 1000 mm und mit 50 Doppelschichten 1225 mm. Als Standzeitkriterium diente das Erreichen einer Verschleißmarkenbreite von 0,2 mm. Werden statt einer einzigen Doppelschicht aus $CrC_{0.4}$ und TiN z. B. zehn Doppelschichten, wie in Figur 5 angedeutet, auf den Werkzeuggrundkörper **3** aufgebracht, so wird während der Beschichtung der Niedervoltbogen **40** zehnmal abwechselnd auf je eine der beiden Tiegelhälften **30a** und **30b** gelenkt.

Anstelle als Werkzeuggrundkörpermaterial einen Schnellstahl HSS S6-5-2-10 zu verwenden, können auch andere Schnellstähle sowie Hartmetalle, Cermet, Kaltarbeitsstähle und Warmarbeitsstähle verwendet werden.

Anstelle die freie, an der Werkzeugaußenseite liegende Oberschicht der Doppelschicht aus $CrC_x$ auszubilden, kann auch eine hexagonal kristallisierende, in **Figur 4a** dargestellte Chromstickstoffkristallschicht aufgebracht werden, wobei die Summe der Schichtbereiche mit kubischen Phasen von Cr und CrN kleiner als dreißig Volumenprozent beträgt. Die Herstellung und die Standzeiten werden anhand eines Beispiel, bei dem zehn Doppelschichten aufgebrachte sind, beschrieben. x liegt hier im Bereich zwischen 1 und 0,2, d.h. das Mischungsverhältnis von Chrom zu Stickstoff liegt zwischen 5 : 1 und 1 : 1. Zur Durchführung der Beschichtung wurde während der Chrombeschichtung ein Stickstofffluß von 120 Standardkubikzentimeter pro Minute und während der Titanbeschichtung ein Azetylenfluß von 40 Standardkubikzentimeter pro Minute eingestellt, was ein x von 0,3 ergab. Die Beschichtungszeiten wurden so eingestellt, daß sich eine Gesamtschichtdicke von 4 $\mu$m ergab.

Zerspanungsversuche mit den erfindungsgemäß beschichteten Werkstücken 3 mit einem Werkzeuggrundkörper aus Schnellstahl (HSS), deren freie, an der Werkzeugaußenseite liegenden Oberschicht **1a** eine $CrN_x$-schicht ist, wurden an Inconel 618 - einer kubisch kristallisierenden Nikkellegierung - mit einer Schnittgeschwindigkeit von 30 m/min und einem Vorschub von 0,05 mm/Umdrehung durchgeführt. Die Zustellung für dieses Umfangsfräsen war 3mm. Für unbeschichtete oder nur mit TiN beschichtete Werkzeuge wurde vergleichsweise ein Standweg von 7 m erhalten, wobei als Standwegkriterium ein Überschreiten einer Verschleißmarkenbreite um 0,2 mm auf der Freifläche dient. Mit nur einer einzigen, nicht erfindungsgemäßen Beschichtung aus $CrN_x$ konnte ein Standweg von 14 m erreicht werden. Mit den erfindungsgemäßen zehn Doppelschichten wurde jedoch ein Standweg von zwanzig Meter erhalten. In einem Parallelversuch wurden Fräser mit 2 $\mu$m Titannitrid ionenplattiert und danach mit 3$\mu$m Titandiborid durch Kathodenzerstäubung beschichtet. Diese Fräser versagten bereits nach 3 m. Es wird angenommen, daß der rasche Verschleiß des Titandiborids auf die hohe Löslichkeit des Titans im Nickel des Inconels zurückzuführen ist.

Wie Zerspanungsversuche gezeigt haben, eignen sich mit einer oder mehreren Doppelschichten versehene Schnellstähle, wenn ihre freie an der Werkzeugaußenseite liegende Oberschicht **1a** aus einem kubischen Chrom-Kohlenstoffmischkristall ($CrC_x$) besteht, besonders zur Bearbeitung von hexagonal kristallisierenden Titanlegierungen und wenn ihre freie an der Werkzeugaußenseite liegende Oberschicht **1a** aus einem hexagonalen Chrom-Stickstoffmischkristall ($CrN_x$) besteht besonders zur Bearbeitung von kubisch kristallisierendem Nickel und Kupfer sowie Nickellegierungen mit Chrom, Eisen und Kupfer.

Anstelle einer reinen Titannitridschicht als Unterschicht **1b** kann auch eine Titankarbonitridschicht ($TiC_xN_{1-x}$) verwendet werden, wobei x zwischen den Werten 0 und 0,4 liegen kann. Eine Titankarbonitridschicht ($TiC_xN_{1-x}$) wird erhalten, wenn bei der Herstellung dieser Schicht den Stickstofffluß Azetylen beigemischt wird. Eine Titankarbonitridschicht hat gegenüber einer reinen Titannitridschicht eine höhere Härte und eine höhere Zähigkeit.

Das in der Unterschicht **1b** enthaltene Element der Gruppe IVb des Periodensystems ist vorzugsweise Titan. Das Element bzw. Titan macht vorzugsweise den Hauptanteil der Schicht aus, es kann aber auch nur 30 - 40% ausmachen.

Bei der Herstellung der Chromkohlenstoffkristallschicht wurde aufgrund der in die Vakuumkammer **19** eingeleiteten Azetylenzuflußmenge ein Mischungsverhältnis zwischen Chrom und Kohlenstoff von 5 : 1 bis 1 : 0,8 und analog für die Chromstickstoffkristallschicht anhand des Stickstoffzuflusses ein Mischungsverhältnis zwischen Chrom und Stickstoff von 5 : 1 bis 1 : 1. Die Härtezahlen ändern sich nur geringfügig und liegen immer oberhalb 1800 HK. Die Chromstickstoffkristallschicht kann auch durch Einleiten von Azetylen während des Bedampfungsvorganges als Chromkarbonitridkristallschicht ausgebildet werden. Das C : N- Mischverhältnis darf max. 1 : 1 betragen, wobei die Kristallstruktur angepaßt sein sollte.

Für die Bearbeitung von Kupfer eignen sich vor allem Werkzeuge mit hexagonal kristallisierenden CrN- bzw. CrCN-Schichten als Werkzeugaußenseite. Als Beispiel sei das Kaltumformen von Kupferelektroden mit erfindungsgemäß beschichteten HSS-Werkzeugen genannt. Mit unbeschichteten Werkzeugen konnten im Mittel 30 000 Kupferelektroden hergestellt werden. Durch eine einfache, nicht erfindungsgemäße TiN - Beschichtung wurde keine wesentliche Verbesserung erzielt. Eine Doppelschicht TiN - $CrN_{0.3}$ ermöglichte die Herstellung von 100 000 Kupferelektroden und mit einer TiN - $CrC_{0.15}N_{0.15}$ - Schicht konnten im Mittel 150 000 Kupferelektroden umgeformt werden.

Neben der Chrom-Kohlenstoff- bzw. der Chrom-Stickstoffkristallschicht erhöht auch eine Chrom-Kohlenstoff-Stickstoffschicht die Standzeit der Werkzeuge, wie obige Zerspanversuche zeigen, signifikant.

Es wird vermutet, daß die hohe Standzeit eines Werkzeugs, dessen freie Schicht im wesentlichen aus einer kubischen Chrom-Kohlenstoff-Kristallschicht besteht, wobei die Summe der Schichtbereiche mit orthorhombischen Phasen von $Cr_7C_3$ und $Cr_3C_2$ kleiner als dreißig Volumenprozent ist, bei der Bearbeitung von Titan und Titanlegierungen darauf beruht, daß ein hoher Kaltverschweißwiderstand, d.h. ein geringes Vermögen zur Kaltverschweißung (engl.: galling) vorliegt. Ein besonders hoher "Widerstand" gegen Kaltverschweißen wird erreicht bei geringer (chemischer) Löslichkeit und unterschiedlicher Kristallgitterstruktur. Die Löslichkeit von Chrom in Titan beträgt maximal 0,5 Atomprozent und die Chromkohlenstoffkristallschicht weist gegenüber Titan oder Titanlegierungen eine unterschiedliche Kristallstruktur auf. Für hexagonal kristallisierendes $\alpha$-Titan sind drei kristallographische Ebenen mit der höchsten Flächenbelegung in den **Figuren 2b**, **2c** und **2d** dargestellt. Die angegebenen Gitterkonstanten (in pm) verändern sich für bekannte Legierungen des $\alpha$-Titan nur unwesentlich. Man erkennt leicht, daß für die 001-Ebene aufgrund der Winkel und für die anderen Ebenen aufgrund der Atomabstände eine gute kristallografische Übereinstimmung ausgeschlossen ist, d. h. die Kristallgitterstrukturen sind zueinander unterschiedlich.

Die hohe Standzeit eines Werkzeugs, dessen freie Schicht im wesentlichen aus einer hexagonalen Chrom-Stickstoff-Kristallschicht besteht, wobei die Summe der Schichtbereiche mit kubischen Phasen von Cr und CrN kleiner als dreißig Volumenprozent ist, bei der Bearbeitung von kubisch kristallisierendem Kupfer und Nickel sowie von Nikkellegierungen mit Chrom, Eisen und/oder Kupfer beruht darauf, daß die Chromstickstoffkristallschicht gegenüber kubisch kristallisierendem Kupfer und Nickel sowie seinen Legierungen mit Chrom, Eisen und/oder Kupfer eine unterschiedliche Kristallstruktur aufweist. Die Gitterparameter mit der höchsten Flächenbelegung sind für reines Nickel in den **Figuren 4b**, **4c** und **4d** dargestellt. Durch Legieren mit den oben genannten Elementen findet praktisch keine Veränderung der Gitterparameter (in pm) statt. Man erkennt auch für diese Kombination, daß eine kristallographische Übereinstimmung zwischen der Chromstickstoffkristallschicht und Kupfer, Nikkel bzw. Nickellegierungen mit Chrom, Eisen und/oder Kupfer hinsichtlich der Winkel und der Atomabstände ausgeschlossen ist.

Eine gute Löslichkeit eines Elements der äußeren freien Schicht des bearbeitenden Werkzeugs im Material des zu bearbeitenden Werkstücks und/oder eine gute kristallografische Übereinstimmung der äußersten freien Schicht des Werkzeugs mit der kristallografischen Struktur des zu bearbeitenden Werkstücks bewirkt bei zerspanenden bzw. umformenden Werkzeugen ein lokales Kaltverschweißen zwischen Werkstück und Werkzeug, welches wiederum zu Ausbrüchen in der Schicht führen würde.

Unter unterschiedlicher Kristallgitterstruktur im Patentanspruch 1 werden entweder unterschiedliche Kristallsystem (tetragonal, rhombisch, hexagonal, etc.) oder gleiche Kristallsysteme verstanden, bei denen sich die Gitterabstände derart unterscheiden, daß kein Mischkristall bildbar ist, d.h. sie sich in der Regel mindestens um fünfzehn Prozent unterscheiden.

Ferner wird angenommen, daß die unterhalb der Chrom-Kohlenstoff- bzw. der Chrom-Stickstoffmischkristallschicht liegende Titan-Kohlenstoff-Stickstoffschicht als Diffusionsbarriere wirkt, wodurch eine hohe chemische Stabilität und ebenfalls eine hohe Standzeit des Werkzeuges erreicht wird. Es wird angenommen, daß beim Zerspanen punktuell auf der Spanfläche hohe Temperaturen erreicht werden, welche ohne erfindungsgemäße Beschichtung zum Auskolken am Werkzeug führen.

Neben den schon oben erwähnten Nichteisenmetallen können auch Zink- oder Aluminiumlegierungen bearbeitet werden.

Bei der Abscheidung der Schichten aus der Gasphase haben sich PVD-Verfahren (Physical Vapor Deposition) und insbesondere Ionenplattierung bewährt. Dieses Verfahren liefert Schichten mit einer wesentlich feineren Kornstruktur als CVD-Verfahren. Die Kornstruktur der erfindungsgemäßen Schichten läßt sich aus der Linienbreite ihrer Röntgenlinien bestimmen, die größer als 0,3 Grad ist. Ferner weisen die erfindungsgemäßen Schichten eine große Zahl von Fehlstellen auf, deren Versetzungsdichte charakteristisch für eine ionenplattierte Schicht ist. Die große Zahl von Fehlstellen ergibt eine hohe Zähigkeit der Schichten.

**Patentansprüche**

1. Beschichtetes Werkzeug zur Bearbeitung von Nichteisenmetallen und deren Legierungen, insbesondere von Titan-, Nickel- und Kupferlegierungen, mit wenigstens einer aus einer Ober- und einer Unterschicht bestehenden Doppelschicht (**1**), wobei die Unterschicht ein Element der Gruppe IVB des Periodensystems enthält, **dadurch gekennzeichnet**, daß die freie, an der Werkzeugaußenseite liegende Oberschicht (**1a**) der Doppelschicht (**1**) im wesentlichen aus einem eine geringe Löslichkeit und/oder eine unterschiedliche Kristallgitterstruktur gegenüber Nichteisenmetallen und deren Legierungen aufweisenden Nitrid, Karbid oder Karbonitrid des Chroms besteht, um Kaltverschweißung bei der Bearbeitung des Nichteisenmetalls bzw. der Nichteisenmetallegierung zu vermeiden.

2. Werkzeug nach Anspruch 1, **dadurch gekennzeichnet**, daß das Chrom-Nitrid, Chrom-Karbid oder Chrom-Karbonitrid der Oberschicht eine geringe Löslichkeit und/oder eine unterschiedliche Kristallgitterstruktur gegenüber Titan und/oder Nickel und/oder Kupfer und/oder deren Legierungen hat.

3. Werkzeug nach Anspruch 1 oder 2, **dadurch gekennzeichnet**, daß das Mischungsverhältnis von Chrom zu Stickstoff des Chrom-Nitrids oder Chrom-Karbonitrids der Oberschicht in einem Verhältnis zwischen 5 : 1 und 1 : 1 oder das Mischungsverhältnis von Chrom zu Kohlenstoff des Chrom-Karbids oder Chrom-Karbonitrids der Oberschicht in einem Verhältnis zwischen 5 : 1 und 1 : 0,8 liegt.

4. Werkzeug nach einem der Ansprüche 1 bis 3, **dadurch gekennzeichnet**, daß die Unterschicht (**1b**) der Doppelschicht (**1**) aus $TiC_xN_{1-x}$ besteht, wobei x im Bereich zwischen 0 und 0,4 liegt.

5. Werkzeug nach einem der Ansprüche 1 bis 4, **dadurch gekennzeichnet**, daß die einzelnen Schichten aus der Gasphase auf die Werkstückoberfläche abgeschieden sind.

6. Werkzeug nach Anspruch 5, **dadurch gekennzeichnet**, daß die einzelnen Schichten mittels PVD (Physical Vapor Deposition) und/oder Ionenplattierung abgeschieden sind.

7. Werkzeug nach einem der Ansprüche 1 bis 6 zum Zerspanen von harten Nichteisenmetallen und deren Legierungen, **gekennzeichnet durch** eine Dicke der Doppelschicht (**1**) bzw. der Doppelschichten zwischen 2 und 4 $\mu$m.

8. Werkzeug nach einem der Ansprüche 1 bis 7 zum Zerspanen von hexagonal kristallisierenden Titanlegierungen, **dadurch gekennzeichnet**, daß die oberste, freie Oberschicht (**1a**) eine im wesentlichen kubische, aus Chrom und Kohlenstoff gebildete Kristallstruktur aufweist, wobei die Summe der Schichtbereiche mit anderer, insbesondere orthorhombischer Struktur kleiner als dreißig Volumenprozent ist.

9. Werkzeug nach einem der Ansprüche 1 bis 7 zum Zerspanen von kubisch kristallisierenden Nickellegierungen, **dadurch gekennzeichnet**, daß die oberste, freie Oberschicht (**1a**) eine im wesentlichen hexagonale, aus Chrom und Stickstoff gebildete Kristallstruktur aufweist, wobei die Summe der Schichtbereiche mit anderer, insbesondere kubischer Struktur kleiner als dreißig Volumenprozent ist.

10. Werkzeug nach einem der Ansprüche 1 bis 6 zum Umformen von Nichteisenmetallen, **gekennzeichnet durch** eine Schichtdicke der Doppelschicht (**1**) bzw. der Doppelschichten zwischen 3 und 10 $\mu$m.

Fig. 1

1 {
1a
1b

3

Fig. 2a

407,9

288,4

Fig. 2b

295,0

468,6

Fig. 2c

510,9

468,6

Fig. 5

1 {
1a
1b

1 {
1a
1b

1 {
1a
1b

3

Fig. 2d

295,0

60°

120°

78,6°

657,8

101,4°

833,3

Fig. 4a

Fig. 4d

60°

498,4

498,4

352,4

352,4

Fig. 4b

498,4

352,4

249,2

Fig. 4c

39

22

21

27

26

45

25

40

19

43

36

35

34

20

3

33

31a

31b

III

III

43

32

b

41

a

37

47

46

30a

30b

29

Fig. 3

48